# EUROPEAN PATENT SPECIFICATION

(11) **EP 0 437 355 B1**
(45) Date of publication and mention of the grant of the patent: **05.06.1996**
(21) Application number: 91300159.0
(22) Date of filing: 09.01.1991
(51) Int. Cl.: C23C 16/30, C23C 16/44, H01L 33/00, C09K 11/08

(54) **Process and apparatus for preparing a thin film electroluminescent device**
Verfahren und Anlage zum Herstellen einer Dünnfilm-Elektroluminescentenvorrichtung
Procédé et appareillage pour fabriquer un dispositif électroluminescent à film mince

(30) Priority: 09.01.1990 JP 3190/90
(43) Date of publication of application: 17.07.1991
(73) Proprietor: SHARP KABUSHIKI KAISHA, Osaka 545 (JP)
(72) Inventor: Tanaka, Koichi, Nara-shi, Nara (JP); Mikami, Akiyoshi, Yamatotakada-shi, Nara (JP); Taniguchi, Kouji, Shiki-gun, Nara (JP); Okibayashi, Katsushi, Sakurai-shi, Nara (JP); Terada, Kousuke, Tenri-shi, Nara (JP); Yamashita, Takuo, Tenri-shi, Nara (JP); Ogura, Takashi, Nara-shi, Nara (JP); Nakaya, Hiroaki, Tenri-shi, Nara (JP); Yoshida, Masaru, Ikoma-Gun, Nara (JP); Nakajima, Shigeo, Nara-shi, Nara (JP)
(74) Representative: Brown, Kenneth Richard

(56) References cited:
- EP-A- 0 342 063
- US-A- 4 548 159
- US-A- 4 582 720

## Description

### FIELD OF THE INVENTION

The present invention relates to a process and apparatus for preparing a thin film electroluminescent device.

### BACKGROUND OF THE INVENTION

There have been proposed many plain display devices which employ liquid crystal, plasma or electroluminescent thin film. Among them, the thin film electroluminescent devices are mainly used for displays of office automation apparatus or testing apparatus, because the device is light and thin. Recently, the devices which have a display capacity of 1,152 x 900 dots and a gradation function of 16 steps have been commercially available. Thus, as increasing information to be displayed, the thin film electroluminescent devices having larger area and larger size are desired.

The electroluminescent devices which have been practically used have an electroluminescent layer of ZnS:Mn which is generally produced by an electron beam deposition method. However, for producing the devices having such larger area and larger size, the electron beam evaporation method encounters some problems. For example, a gas exhausting system is employed in the method, but it is required that its exhausting capacity be increased with the increase of the size of the substrate. It is however difficult to make such exhausting system having a large exhausting capacity. It is also reported in Applied Physics 51, 821 (1982) that a temperature of the substrate changes the Mn concentration or the quality of the ZnS:Mn film prepared by the electron beam deposition method. However, it is very difficult to keep the temperature of the substrate throughout the large surface area.

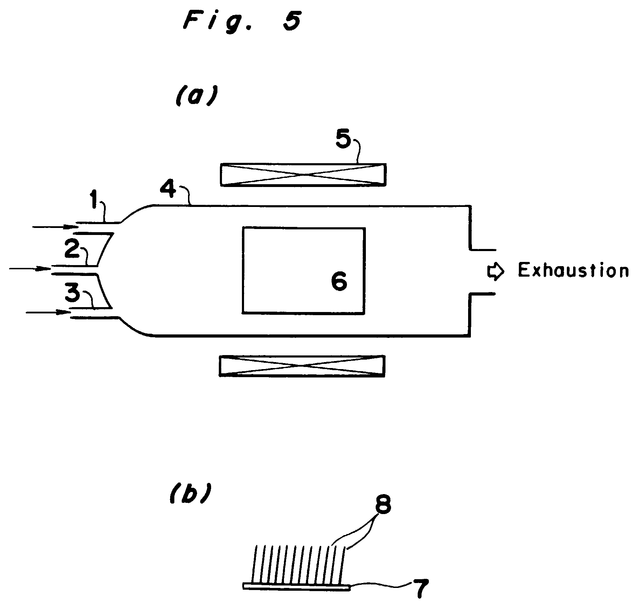

A chemical vapor deposition (CVD) method is also known to the art as a method forming a uniform thin film on a large area and is popular in the semiconductor industry. Fig. 5(a) schematically shows an apparatus for the CVD method and Fig. 5(b) schematically shows a substrate holder. In the apparatus, a source material gas is introduced through supply tubes 1, 2 and 3 which are arranged at one end of a reaction tube 4. The reaction tube 4 is exhausted by an exhausting system through the other end to keep the reaction tube 4 in vacuo. The reaction tube 4 is surrounded with furnaces 5 which control the temperature of substrates 8. The substrates 8 are held by a holder 7 in a uniformly heating area 6 in which a certain temperature is kept fixed. If the source material gas is composed of SiH₄ and NH₃, an Si₃N₄ film which is employed as an insulation film for LSI is formed by the following reaction: ${\text{SiH}}_{\text{4}} {\text{+ 4/3NH}}_{\text{3}} {\text{→ 1/3Si}}_{\text{3}} {\text{N}}_{\text{4}} {\text{+ 4H}}_{\text{2}}$

US-A-4 548 159 discloses a CVD apparatus comprising a cylindrical wafer boat engaging wafers and having in the lower hemicylinder gas diffusion openings in a gas diffusion zone.

In cases where the CVD apparatus is operated on an industrial scale, many substrates are put in the uniformly heating area 6, but non-uniformity of the deposition film thickness generally occurs for two reasons. One concerns the diffusion constant of a source material gas and the other concerns the concentration difference of the source material gas in the flowing direction resulting from a higher consumption of the source material at its earlier contacting position with the substrate. The former effect results in non-uniformity of the deposited film thickness throughout the surface, and the latter effect results in the reduction of film thickness along the source gas stream. This former effect, however, can be alleviated by reducing an inside pressure of the reaction tube and by increasing the diffusion constant, and the latter effect can be alleviated by increasing a feeding rate of the source material in terms of the source material gas flow in comparison with the consumption rate of the source material so as to make the source material gas concentration substantially uniform in the flowing direction.

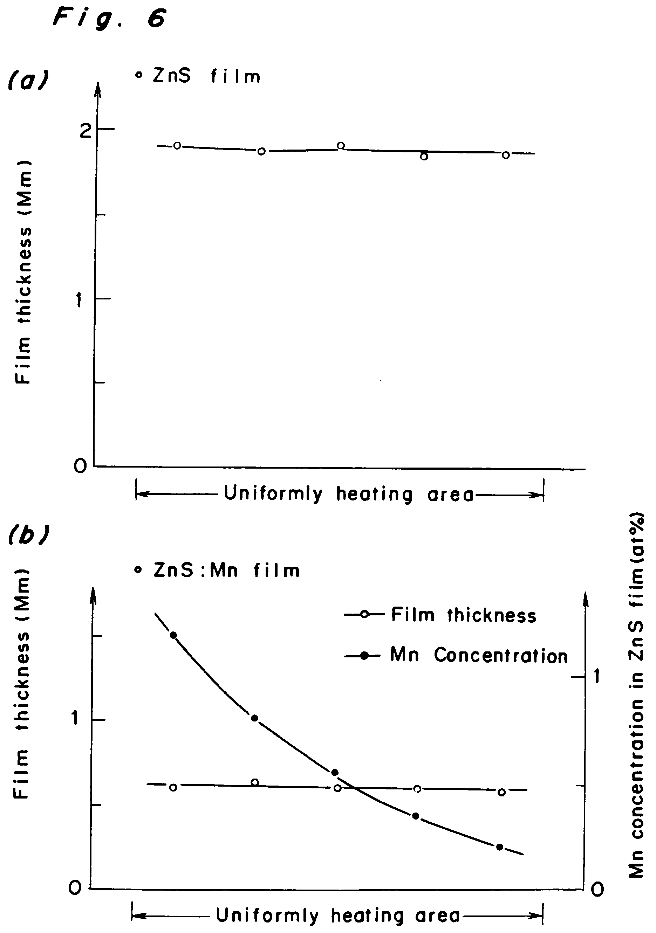

The CVD method has been little applied in the past for forming a luminescent layer in a thin film electroluminescent device, but the present inventors attempted to study its use for forming a larger size luminescent layer for a thin film electroluminescent device on an industrial scale. A CVD apparatus as shown in Fig. 5 was employed for forming a ZnS film. ZnS powder was heated at 900 to 1,000°C and the vapor was sent to the reaction tube 4 with H₂ gas. A glass substrate was employed and its temperature was set at 450° to 550°C. The inside pressure of the reaction tube 4 was kept at 10° N/m² (10⁻² torr) and deposition was conducted for 60 minutes. The resulting ZnS film was a polycrystalline film having zincblende structure and oriented in the (111) direction. Fig. 6(a) is a graph of film thickness distribution over the uniformly heating area, and clearly shows the uniformity of the film thickness.

Next, a ZnS:Mn film was prepared using the same apparatus. The deposition conditions were the same, provided that an Mn gas source was fed. The Mn gas was introduced in the form of MnCl₂ gas prepared by heating Mn at 800° to 900°C and then mixing with HCl gas to react as follows: ${\text{Mn}}_{\text{(S)}} {\text{+ 2HCl}}_{\text{(g)}} {\text{→MnCl}}_{\text{2(g)}} {\text{+ H}}_{\text{2(g)}}$Fig. 6(b) is a graph which indicates an Mn concentration and a ZnS:Mn film thickness distribution in the uniformly heating area. The results show that the film thickness reduced to 1/3, but has good uniformity. The Mn concentration varies widely from relatively high in the upstream region to relatively low in the downstream region. The ZnS:Mn film has a wurtzite structure. It is believed that the reduction of the film thickness is caused by etching of the ZnS film by means of HCl gas which occurs by the addition of the MnCl₂ gas.

As is apparent from the above results, the ZnS:Mn film obtained by the reduced-pressure CVD method has a drawback of non-uniformity in the Mn concentration. The above results are obtained by a horizontal furnace, but if it is conducted by a perpendicular furnace, the same non-uniformity of Mn concentration would occur.

It is believed that the reason for the non-uniformity of Mn concentration is as follows: Since a vapor pressure of MnCl₂ is low in the substrate temperature area, the deposition of Mn occurs easily, so that the Mn in the source material gas is consumed more in the upstream region and the Mn concentration therefore reduces in the downstream region. The non-uniformity may be improved by increasing the flow rate of the source material gas, but the source material gas is sufficiently fed in view of the uniformity of the ZnS:Mn film thickness. If the flow rate of the source material gas is increased, a conversion rate of the source material to the deposited film is also reduced and a production cost becomes expensive. Also, the increase of the flow raises the inside pressure of the reaction tube, which often gives rise to a non-uniformity caused by the increase of diffusion constant and adversely affects the uniformity of the ZnS film which is a host material of the ZnS:Mn film.

The abovementioned problems are common with the luminescent center of the thin film electroluminescent film device produced by the reduced-pressure CVD method, i.e. Tb in ZnS:Tb, Eu in ZnS:Eu film and Ce in SrS:Ce.

### SUMMARY OF THE INVENTION

According to one aspect of the invention, there is provided a process as claimed in claim 1. According to another aspect of the present invention, there is provided an apparatus as claimed in claim 10. Another aspect of the present invention is the use of the apparatus, as claimed in claim 16.

The present invention may provide an improvement of the chemical vapor deposition (CVD) process for preparing an electroluminescent device having a large area and a large size. A process in an embodiment of the present invention comprises forming a luminescent layer on a substrate by reduced-pressure chemical vapor deposition method wherein a source material gas is introduced into a reaction chamber; an improvement being present in that;
the reaction chamber includes a screening means which screens the source material gas flow in the chamber to form a first area in which the gas is flowing and a second area in which the gas substantially does not flow,
the screening means has apertures for connecting the first area and second area,
the substrate is placed in the second area, to which the source material is supplied by means of gas diffusion.

In an embodiment of the present invention, there is also provided apparatus for performing such a process.

The screening means is not limited as long as the flow of the source material gas is screened in the substrate area. It can be formed by surrounding the substrate area with boards. It also can be a container box having some apertures and put on the substrates area.

The apertures in the screening means are formed such that the screening effect of the source material gas flow is not lowered. The shape and position of the apertures can be determined in view of a concentration of the luminescent center atom in the source material gas. For example, the shape includes holes, slits or mesh. The shape and position of the apertures are controlled such that at the higher concentration area the apertures are smaller and at the lower concentration area they are larger, whereby the amount of diffusion of the luminescent center atoms through the apertures is substantially equal at any position. The apertures and screening means are designed such that the amount of the luminescent center atoms is common around all the substrates.

In the above embodiment of the present invention, the substrates are placed in the second area in which the source material gas flow is little present. In this area, the feed of the source material gas is mainly conducted by diffusion through the apertures and little by gas stream. Accordingly, the luminescent film is made from the source material fed by the diffusion, so that the concentration of the luminescent center atom can be made uniform.

### PREFERRED EMBODIMENTS OF THE INVENTION

Preferred embodiments of the invention will now be described by way of example with reference to the accompanying drawings.

### BRIEF EXPLANATION OF THE DRAWINGS

Fig. 1 schematically shows an apparatus employed in this example.

Fig. 2 schematically shows an exploded view of the container 11 of Figure 1.

Fig. 3(a), (b) and (c) show schematical views of other embodiments of the container.

Fig. 4 shows a graph of L-V (luminance - applied voltage) characteristics with respect to the above obtained EL device and another conventional EL device which was prepared by the electron beam deposition.

Fig. 5(a) schematically shows an apparatus for chemical vapor deposition (CVD) and Fig. 5(b) schematically shows a substrate holder.

Fig. 6(a) is a film thickness distribution in the uniformly heating area, Fig. 6(b) is a graph which indicates an Mn concentration and a ZnS:Mn film thickness distribution in the uniform by heating area.

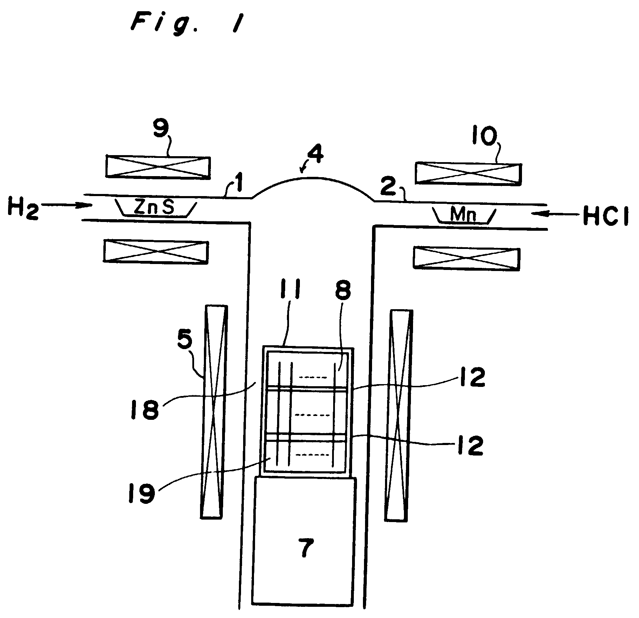

In the example illustrated in Fig. 1, a source material (ZnS) was heated to 900° to 1,000°C in a source furnace 9 and the resultant vapor was introduced through a supply tube 1 into a reaction chamber 4 together with a carrier gas (H₂). A different carrier gas, for example He gas, could be used. Mn metal was heated to about 800° to 900°C in a source furnace 10, to which HCl gas was introduced and reacted as follows; ${\text{Mn}}_{\text{(S)}} {\text{+ 2HCl}}_{\text{(g)}} {\text{→ MnCl}}_{\text{2(g)}} {\text{+ H}}_{\text{2(g)}}$

The resulting MnCl₂ gas was introduced through a supply tube 2 into the reaction chamber 4. The introduction of the source material gas could be done by direct introduction of ZnCl₂ gas, H₂S gas, MnCl₂ gas and the like.

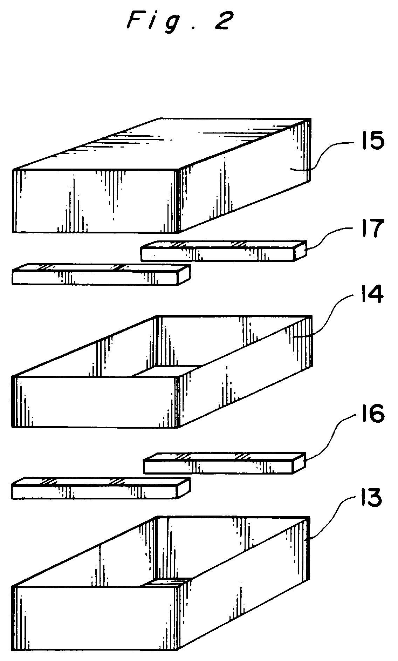

A substrate 8 was a glass substrate (14 cm x 17 cm) on which a transparent electrode of ITO was formed to about 150 nm (1,500 angstrom) thickness, and thereon a SiO₂ film and Si₃N₄ film were formed to a total of about 250 nm (2,500 angstrom) thickness. Twenty such substrates 8 were placed in a container box 11 having slits 12, of which an enlarged and schematical view is shown in Fig. 2. The container box 11 had base dimensions of 10 cm x 10 cm and a height of 20.6 cm. It was prepared by placing a square tube 14 having a height of 5 cm on a lower box 13 having a height of 7.5 cm with intermediate spacers 16 of 4 mm height, followed by placing an upper box 15 of 7.5 cm height thereon with intermediate 2 mm spacers 17. The container box 11 thus had slit-like apertures formed by the spacers 16 and 17. The first area 18 was formed outside the container box 11 and second area 19 was formed inside it.

The container box 11 was placed on a substrate holder 7 and the substrates 8 therein were heated by a substrate furnace 5 to a temperature of 450° to 600°C. The pressure inside the reaction tube 4 was kept at about 10°N/m² (10⁻² torr). Deposition was conducted at a substrate temperature of about 550°C for 60 minutes.

The physical properties of the deposited ZnS:Mn film were evaluated and the results are shown in Table 1. For a comparison, the same deposition was conducted without the container 11 and the same evaluations were carried out. The results also are shown on Table 1.

**Table 1**

| | | |
|---|---|---|
| | Without container | With container |
| Film thickness in nm (Å) (Distribution %) | 800 - 750 (8,000 - 7,500) (± 3.2) | 760 - 740 (7,600 - 7,400) (± 1.3) |
| Growth rate in nm/min (Å/min) | 12.9 (129) | 12.5 (125) |
| Mn concentration in film in atomic % (Distribution %) | 0.32 - 0.96 (± 50) | 0.37 - 0.43 (± 7) |

The measurement was conducted at 6 points on the luminescent layer (10 cm x 13 cm). As can be seen from Table 1, growth rate was reduced about 5%, but film thickness and Mn concentration distribution were improved. In particular, Mn concentration distribution was significantly improved. Since an optimum Mn concentration of a ZnS:Mn device lies generally within the range of 0.3 to 0.5 atomic %, the film obtained by the above example of the present invention was in this optimum range and no difference in regard with the physical properties of the ZnS:Mn film was observed between the substrates.

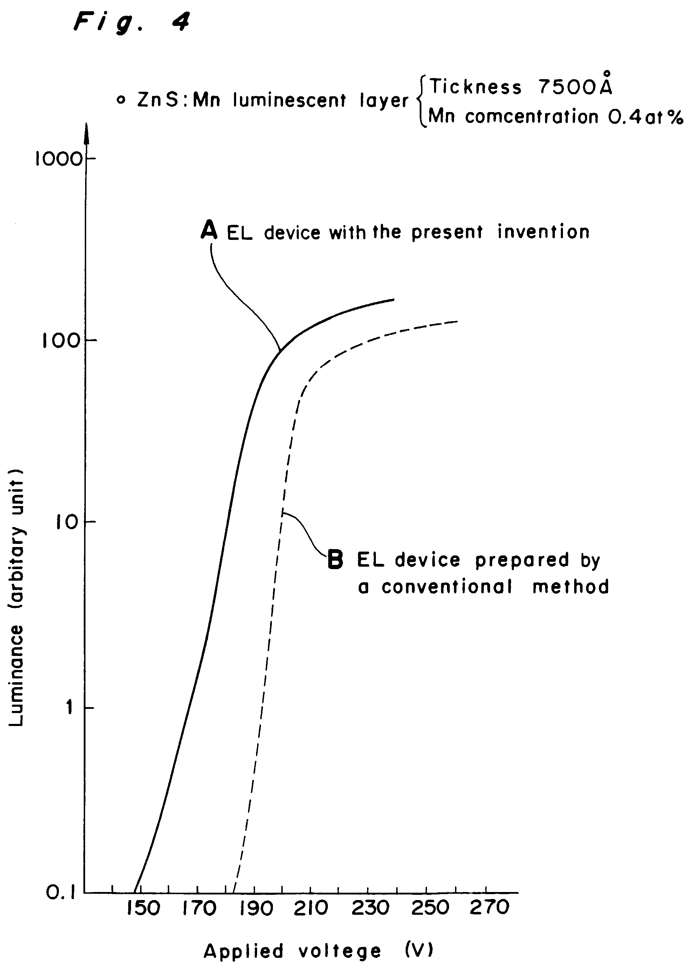

Si₃N₄ film and Al₂O₃ film (both total about 150nm (1,500 angstrom)) and Al film (about 300nm (3,000 angstrom)) were deposited on ZnS:Mn film in this order to obtain an electroluminescent (EL) device. L-V (luminance - applied voltage) characteristics were measured for the above obtained EL device and for a conventional EL device which was prepared by electron beam deposition, and Fig. 4 shows the results. Although the thickness of the luminescent film and an MN concentration were common, the EL device prepared in accordance with the present invention emitted at lower voltage and had a higher saturated luminescence (see line A of Fig. 4) than the conventional EL device (see line B of Fig. 4). The reason seems to be that the ZnS:Mn film prepared by the electron beam deposition method has a region of low efficiency from the substrate to 300nm (3,000 angstrom), but in the film produced in accordance with the present invention such a region of low efficiency is less than 100 nm (1,000 angstrom) thick according to the observation of SEM. This difference of the film structure provides a high luminance at low voltage and high saturated luminescence.

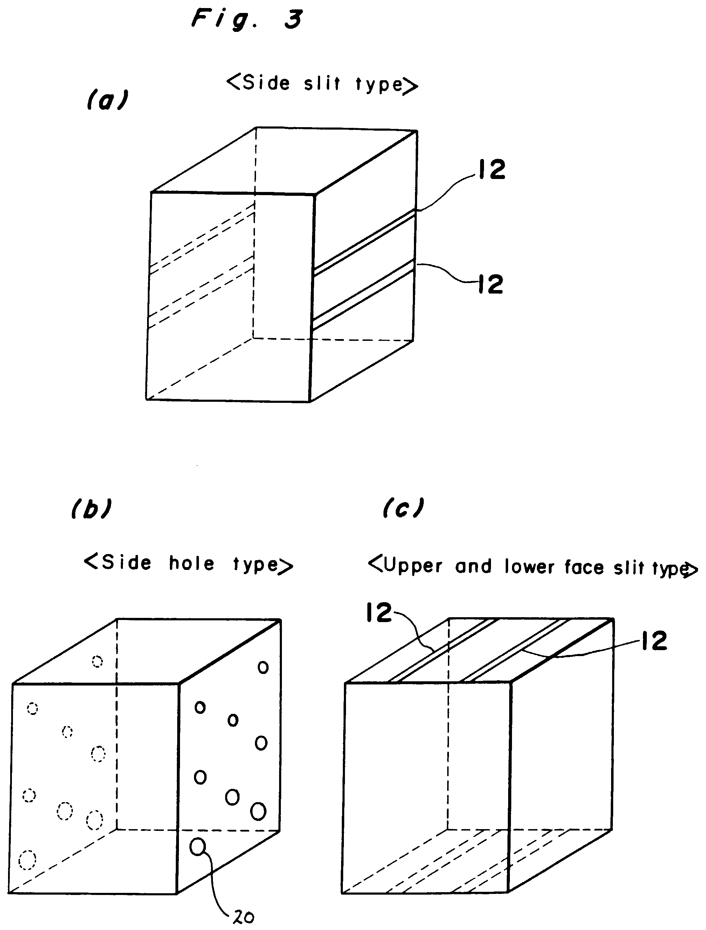

The above description relates to one example, but the shape and size of the container 11 can be varied according to the shape and size of the substrate 8 and film-forming conditions. In the above example, the apertures are slits, but holes 20 can be used instead. The slits may be formed in the upper and lower surfaces of the container. Fig. 3(a), (b) and (c) show schematical views of the above described apertures. The invention, however, is not limited to these forms of apertures. The form and arrangement of apertures may be determined such that the source material gas is constantly fed. In the above example, a ZnS:Mn film was produced, but other films, such as ZnS:Tb, CaS:Eu and SrSl:Ce can be produced by the above method.

Using the process according to the present invention, a thin film EL device having a large area can be produced on an industrial scale. Also the process of the present invention has highly efficient utilization of the source material gas and lowers production costs.

The invention being thus described, it will be obvious that the same may be varied in many ways. Such variations are not to be regarded as a departure from the scope of the invention.

## Claims

1. A reduced-pressure CVD process for the deposition of a material layer on a substrate (8), comprising:
causing a source material gas to flow through a reaction chamber (4); accommodating the substrate (8) within a zone (19) in said reaction chamber in which substantially no gas flow exists, and diffusing the source material gas through aperture means (12, 20) into the zone (19), characterised in that the aperture means (12, 20) has a small area in an area of high concentration of said source material gas outside the zone (19) and a large area in an area of low concentration of said source material gas outside the zone (19) such that the concentration of said source material gas in said zone is substantially uniform.

2. A process according to claim 1 wherein the layer is a luminescent layer and said source material gas includes a luminescent centre element, the concentration of the luminescent centre element being substantially uniform in said zone.

3. A process according to claim 2 wherein said source material gas comprises MnCl₂ gas.

4. A process according to claim 3, including reacting Mn with HCl gas to produce said MnCl₂ gas.

5. A process according to any preceding claim, including introducing a further gas into the reaction chamber (4).

6. A process according to claim 5, wherein the further gas comprises:
ZnS and a carrier gas selected from the group H₂, He or Ar.

7. A process according to claim 5 wherein said further gas comprises:
ZnCl₂ gas and H₂S gas.

8. A thin film electroluminescent device produced by a process according to any preceding claim.

9. A device according to claim 8 when dependent on claim 2, having a luminescent layer of ZnS:Mn, ZnS:Tb, CaS:Eu or SeS:Ce.

10. Apparatus for performing a reduced-pressure CVD process for the deposition of a material layer on a substrate (8), said apparatus including a reaction chamber (4), means (2) for introducing into said reaction chamber a source material gas which, in use, flows through said reaction chamber, and means (11) defining within said chamber a zone (19) in which, in use, the substrate (8) is accommodated and substantially no gas flow exists, said zone-defining means including aperture means (12, 20), through which the source material gas diffuses, characterised in that the aperture means (12, 20) has a small area in an area where the concentration of said source material gas outside the zone (19) is high, and a large area in an area where the concentration of said source material gas outside the zone (19) is low, so as to provide substantially uniform concentration of said source material gas in said zone.

11. Apparatus according to claim 10 wherein the aperture means (12, 20) provides an opening area for gas diffusion, which area is greater downstream than upstream, relative to the direction of material gas flow.

12. Apparatus according to claim 11 wherein the aperture means comprises different width slits (12) extending across said direction of flow.

13. Apparatus according to claim 11 wherein the aperture means comprises holes (20).

14. Apparatus according to any one of claims 10 to 13, wherein said zone defining means is a container (11) formed by placing a spacer means (16) between a rectangular tube (14) and a lower box (13) followed by placing a further spacer means (17) and an upper box (15) thereon.

15. Apparatus according to any one of claims 10 to 14, wherein the means (2) for introducing the source material gas is arranged to introduce said source material gas including a luminescent centre element.

16. Use of an apparatus as claimed in claim 15 to produce said material layer comprising a luminescent layer having a substantially uniform concentration of said luminescent centre element on the substrate (8).

## Patentansprüche

1. CVD-Verfahren mit erniedrigtem Druck zur Abscheidung einer Materialschicht auf einem Substrat (8), umfassend:
- Veranlassen, daß ein Quellenmaterialgas durch eine Reaktionskammer (4) strömt;
- Unterbringen des Substrats (8) in einer Zone (19) in der Reaktionskammer, in der im wesentlichen keine Gasströmung besteht; und Diffundieren des Quellenmaterialgases durch eine Öffnungseinrichtungen (12, 20) in die Zone (19); **dadurch gekennzeichnet,** daß die Öffnungseinrichtung (12, 20) in einem Bereich hoher Konzentration des Quellenmaterialgases außerhalb der Zone (19) eine kleine Fläche aufweist, und sie in einem Bereich niedrigerer Konzentration des Quellenmaterialgases außerhalb der Zone (19) eine große Fläche aufweist, so daß die Konzentration des Quellenmaterialgases in der Zone im wesentlichen gleichmäßig ist.

2. Verfahren nach Anspruch 1, bei dem die Schicht eine Lumineszenzschicht ist und das Quellenmaterialgas ein Lumineszenzzentrums-Element enthält, dessen Konzentration in der genannten Zone im wesentlichen gleichmäßig ist.

3. Verfahren nach Anspruch 2, bei dem das Quellengasmaterial MnCl₂-Gas enthält.

4. Verfahren nach Anspruch 3, bei dem Mn mit HCl-Gas zur Reaktion gebracht wird, um das MnCl₂-Gas herzustellen.

5. Verfahren nach einem der vorstehenden Ansprüche, bei dem ein weiteres Gas in die Reaktionskammer (4) eingeleitet wird.

6. Verfahren nach Anspruch 5, bei dem das weitere Gas ZnS und ein aus der aus H₂, He oder Ar bestehenden Gruppe ausgewähltes Trägergas umfaßt.

7. Verfahren nach Anspruch 5, bei dem das Gas ferner ZnCl₂-Gas und H₂S-Gas umfaßt.

8. Dünnfilm-Elektrolumineszenzvorrichtung, die durch ein Verfahren nach einem der vorstehenden Ansprüche hergestellt wurde.

9. Vorrichtung nach Anspruch 8 in Abhängigkeit von Anspruch 2 mit einer Lumineszenzschicht aus ZnS:Mn, ZnS:Tb, CaS:Eu oder SeS:Ce.

10. Vorrichtung zum Ausführen eines CVD-Verfahrens mit erniedrigtem Druck zum Abscheiden einer Materialschicht auf einem Substrat (8), die folgendes aufweist: eine Reaktionskammer (4); eine Einrichtung (2) zum Einleiten eines Quellengasmaterials in die Reaktionskammer, das im Gebrauch durch die Reaktionskammer strömt; und eine Einrichtung (11), die innerhalb der Kammer eine Zone (19) bildet, in der das Substrat (8) im Gebrauch untergebracht ist und in der im wesentlichen keine Gasströmung vorliegt, wobei diese die Zone bildende Einrichtungen eine Öffnungseinrichtung (12, 20) enthält, durch die das Quellenmaterialgas diffundiert, **dadurch gekennzeichnet,** daß die Öffnungseinrichtung (12, 20) in einem Bereich, in dem die Konzentration des Quellenmaterialgases außerhalb der Zone (19) hoch ist, und sie in einem Bereich, in dem die Konzentration des Quellengasmaterials außerhalb der Zone (19) niedrig ist, eine große Fläche aufweist, um für im wesentlichen gleichmäßige Konzentration des Quellenmaterialgases in der Zone zu sorgen.

11. Vorrichtung nach Anspruch 10, bei der die Öffnungseinrichtung (12, 20) eine Öffnungsfläche für Gasdiffusion bildet, die stromabwärts größer als stromaufwärts ist, bezogen auf die Richtung der Materialgasströmung.

12. Vorrichtung nach Anspruch 11, bei der die Öffnungseinrichtung verschiedenbreite Schlitze (12) aufweist, die sich über die Strömungsrichtung erstrecken.

13. Vorrichtung nach Anspruch 11, bei der die Öffnungseinrichtung Löcher (20) aufweist.

14. Vorrichtung nach einem der Ansprüche 10 bis 13, bei der die Zonenbildungseinrichtung ein Behälter (11) ist, der dadurch ausgebildet ist, daß eine Abstandshaltereinrichtung (16) zwischen ein rechteckiges Rohr (14) und einen unteren Kasten (13) gesetzt wird, gefolgt von einem Aufsetzen einer weiteren Abstandshaltereinrichtung (17) und eines oberen Kastens (15) darauf.

15. Vorrichtung nach einem der Ansprüche 10 bis 14, bei der die Einrichtung (2) zum Einleiten des Quellenmaterialgases so ausgebildet ist, daß sie das Quellenmaterialgas einschließlich eines Lumineszenzzentrums-Elements einleitet.

16. Verwendung einer Vorrichtung nach Anspruch 15 zum Herstellen der Materialschicht mit einer Lumineszenzschicht mit im wesentlichen gleichmäßiger Konzentration des Lumineszenzzentrums-Elements auf dem Substrat (8).

## Revendications

1. Procédé CVD (dépôt chimique en phase vapeur) sous pression réduite pour le dépôt d'une couche de matière sur un substrat (8) comprenant les étapes consistant:
à provoquer l'écoulement d'un gaz de matière source à travers une chambre de réaction (4); à placer le substrat (8) à l'intérieur d'une zone (19) de ladite chambre de réaction dans laquelle il n'existe pratiquement pas d'écoulement de gaz, et à diffuser le gaz de matière source dans la zone (19) par l'intermédiaire de moyens formant ouvertures (12, 20), caractérisé en ce que les moyens formant ouvertures (12, 20) ont une faible surface dans une région de forte concentration dudit gaz de matière source à l'extérieur de la zone (19) et une grande surface dans une région de faible concentration dudit gaz de matière source à l'extérieur de la zone (19) de telle sorte que la concentration dudit gaz de matière source dans ladite zone soit sensiblement uniforme.

2. Procédé selon la revendication 1, dans lequel la couche est une couche luminescente et ledit gaz de matière source comprend un élément de centre luminescent, la concentration de l'élément de centre luminescent étant sensiblement uniforme dans ladite zone.

3. Procédé selon la revendication 2, dans lequel ledit gaz de matière source est du gaz MnCl₂.

4. Procédé selon la revendication 3, comprenant la réaction de Mn avec du gaz HCl pour produire ledit gaz MnCl₂.

5. Procédé selon l'une quelconque des revendications précédentes, comprenant l'introduction d'un autre gaz dans la chambre de réaction (4).

6. Procédé selon la revendication 5, dans lequel l'autre gaz comprend:
ZnS et un gaz porteur sélectionné dans le groupe H₂, He ou Ar.

7. Procédé selon la revendication 5, dans lequel ledit autre gaz comprend:
le gaz ZnCl₂ et le gaz H₂S.

8. Dispositif électroluminescent à couche mince produit par un procédé selon l'une quelconque des revendications précédentes.

9. Dispositif selon la revendication 8, lorsqu'elle dépend de la revendication 2, comportant une couche luminescente de ZnS:Mn, ZnS:Tb, CaS:Eu ou SeS:Ce.

10. Appareil pour réaliser le procédé CVD sous pression réduite pour le dépôt d'une couche de matière sur un substrat (8), ledit appareil comprenant une chambre de réaction (4), des moyens (2) pour introduire dans ladite chambre de réaction un gaz de matière source qui, en service, s'écoule à travers ladite chambre de réaction, et des moyens (11) définissant à l'intérieur de ladite chambre une zone (19) dans laquelle, en service, est enfermé ledit substrat (8) et pratiquement aucun écoulement de gaz n'existe, lesdits moyens définissant la zone comprenant des moyens formant ouvertures (12, 20), par l'intermédiaire desquels il y a diffusion du gaz de matière de source, caractérisé en ce que les moyens formant ouvertures (12, 20) ont une faible surface dans une région dans laquelle la concentration dudit gaz de matière source à l'extérieur de la zone (19) est élevée, et une surface importante dans une région dans laquelle la concentration dudit gaz de matière source à l'extérieur de la zone (19) est faible, de manière à obtenir une concentration sensiblement uniforme dudit gaz de matière source dans ladite zone.

11. Appareil selon la revendication 10, dans lequel les moyens formant ouvertures (12, 20) fournissent une région d'ouverture pour la diffusion du gaz, cette région étant plus importante en aval qu'en amont, par rapport à la direction de l'écoulement du gaz de matière.

12. Appareil selon la revendication 11, dans lequel les moyens formant ouvertures comprennent des fentes de largeurs différentes (12) qui s'étendent en travers de ladite direction de l'écoulement.

13. Appareil selon la revendication 11, dans lequel les moyens formant ouvertures se composent d'orifices (20).

14. Appareil selon l'une quelconque des revendications 10 à 13, dans lequel lesdits moyens de définition de zone sont constitués par un récipient (11) formé en plaçant un moyen formant entretoise (16) entre un tube rectangulaire (14) et une boîte inférieure (13), puis en plaçant sur ceux-ci un autre moyen formant entretoise (17) et une boîte supérieure (15).

15. Appareil selon l'une quelconque des revendications 10 à 14, dans lequel les moyens (2) pour introduire le gaz de matière source est conçu de façon à introduire ledit gaz de matière source comprenant un élément de centre luminescent.

16. Utilisation d'un appareil tel que revendiqué dans la revendication 15 pour produire ladite couche de matière comprenant une couche luminescente ayant une concentration sensiblement uniforme dudit élément de centre luminescent sur le substrat (8).
